# EUROPÄISCHE PATENTSCHRIFT

(11) **EP 3 394 983 B1**
(45) Veröffentlichungstag und Bekanntmachung des Hinweises auf die Patenterteilung: **25.06.2025**
(21) Anmeldenummer: 16794230.9
(22) Anmeldetag: 26.10.2016
(51) Int. Cl.: H03K 17/955, H03K 17/96

(54) **VERFAHREN ZUM BETREIBEN EINES SENSORSYSTEMS, SENSORELEMENT SOWIE SENSORSYSTEM**
METHOD FOR OPERATING A SENSOR SYSTEM, SENSOR ELEMENT AND SENSOR SYSTEM
PROCÉDÉ DE FONCTIONNEMENT D'UN SYSTÈME DE DÉTECTION, ÉLÉMENT DE DÉTECTION ET SYSTÈME DE DÉTECTION

(30) Priorität: 21.12.2015 DE 102015226129
(43) Veröffentlichungstag der Anmeldung: 31.10.2018
(73) Patentinhaber: Robert Bosch GmbH, 70442 Stuttgart (DE)
(72) Erfinder: FRANGEN, Joachim, 74081 Heilbronn (DE); SEIZ, Daniel, 71106 Magstadt (DE)
(86) Internationale Anmeldenummer: PCT/EP2016/075800
(87) Internationale Veröffentlichungsnummer: WO 2017/108235

(56) Entgegenhaltungen:
- EP-A1- 3 054 262
- WO-A1-2015/046058
- DE-A1- 102009 029 021
- DE-A1- 102010 064 328
- US-A- 5 914 610
- US-A1- 2007 109 274
- US-A1- 2013 262 004
- US-A1- 2015 227 229

## Beschreibung

### Stand der Technik

Die Erfindung betrifft ein Verfahren zum Betreiben eines Sensorsystems nach dem Oberbegriff des Anspruchs 1. Ferner betrifft die Erfindung ein Sensorsystem zum Durchführen des erfindungsgemäßen Verfahrens.

Ein Verfahren zum Betreiben eines Sensorsystems nach dem Oberbegriff des Anspruchs 1 sowie ein Sensorsystem, das nach einem derartigen Verfahren arbeitet, sind aus der US 2007/0109274 A1 bekannt. Das bekannte Verfahren, das insbesondere im Zusammenhang mit berührungssensitiven Bedienoberflächen Verwendung findet, zeichnet sich insbesondere dadurch aus, dass gleichzeitig mehrere elektrische Felder zwischen den Sensorelementen des Sensorsystems ausgebildet werden, wobei gleichzeitig ein Sensorelement als Sendelektrode und mindestens zwei Sensorelemente als Empfangselektrode wirken.

Ein weiteres Verfahren zum Betreiben eines Sensorsystems nach dem Oberbegriff des Anspruchs 1 sowie ein Sensorsystem, das nach einem derartigen Verfahren arbeitet, sind aus der US 2013/0262004 A1 bekannt. Aus dieser Schrift ist es bekannt, dass gleichzeitig zwei Sensorelemente als Sendeelektrode geschaltet sind, die mit einem als Empfangselektrode wirkenden Sensorelement zusammenwirken.

Aus der DE 10 2009 029 021 A1 der Anmelderin ist ein weiteres Sensorsystem bekannt, das wenigstens ein kapazitives Sensorelement umfasst, dessen von ihm erzeugtes elektrisches Feld sich bei einer Annäherung eines Körpers oder eines Objekts verändert, wobei die Veränderung erfasst und ausgewertet werden kann. Das bekannte Sensorsystem dient insbesondere bei Handhabungsrobotern oder ähnlichen Maschinen bzw. Anlagen dazu, bei Annäherung eines Menschen bzw. eines Objekts an ein sich bewegendes Maschinenteil, beispielsweise einen Roboterarm, die Maschine in einen Sicherheitsmodus zu schalten, bei der die Bewegung des betreffenden Maschinenbauteils gestoppt oder zumindest verlangsamt wird. Dadurch lassen sich insbesondere Verletzungen bei einer Kollision der Handhabungseinrichtung mit einem Menschen bzw. Beschädigungen an Objekten oder der Handhabungseinrichtung vermeiden oder zumindest minimieren. Das bekannte Sensorsystem umfasst vorzugsweise eine Vielzahl von flächig ausgebildeten Sensorelementen, die beispielsweise die gesamte Oberfläche einer Handhabungseinrichtung in Art einer Sensorhaut überdecken und schaltungstechnisch miteinander verbunden sind.

Weiterhin ist es aus der genannten Schrift ebenfalls bekannt, zwei unmittelbar benachbarte Sensorelemente bzw. die zwischen diesen Sensorelementen ausgebildeten elektrischen Felder gleichzeitig zu analysieren, um damit beispielsweise bei einer Maschine vorhandene Lücken oder ähnliches zu überbrücken und/oder die Reichweite der Sensorelemente zu erhöhen. Dabei wird auch das zwischen zwei Sensorelementen ausgebildete elektrische Feld überwacht bzw. analysiert. Wesentlich ist es auch, dass die aus der genannten Schrift bekannten Sensorelemente stets zwei elektrische Potentiale aufweist, d.h., dass bereits von einem einzelnen Sensorelement ein elektrisches Feld ausbildbar ist.

Aus der DE 10 2010 064 328 A1 der Anmelderin ist es weiterhin bekannt, zwei unterschiedliche Sensorelemente eines Sensorsystems durch unterschiedliche Zentraleinheiten gleichzeitig anzusteuern bzw. zu adressieren.

Zum Stand der Technik gehören ebenso die Dokumente US 5 914 610 A, US 2015/227229 A1 sowie WO 2015/046058 A1.

### Offenbarung der Erfindung

Ausgehend von dem dargestellten Stand der Technik liegt der Erfindung die Aufgabe zugrunde, ein Verfahren zum Betreiben eines Sensorsystems nach dem Oberbegriff des Anspruchs 1 derart weiterzubilden, dass damit eine gegenüber dem Stand der Technik erhöhte Sicherheit und/oder ein dichteres Überwachungsfeld erzielt und Annäherungen zwischen den Sensorelementen und einem Körper oder einem Objekt besonders sicher und frühzeitig erkannt werden können.

Diese Aufgabe wird erfindungsgemäß bei einem Verfahren zum Betreiben eines Sensorsystems mit den Merkmalen des Anspruchs 1 gelöst.

Der Erfindung liegt die Idee zugrunde, im Gegensatz zum Stand der Technik nicht nur die elektrischen Felder zwischen zwei einander benachbarten Sensorelementen zu überwachen bzw. auszuwerten, sondern im Extremfall alle elektrischen Felder, die zwischen einem als Sendeelektrode wirkenden ersten Sensorelement und allen anderen, als Empfangselektroden wirkenden zweiten Sensorelementen ausgebildet werden. Konkret schlägt die Erfindung vor, dass das erfindungsgemäße Verfahren derart gestaltet ist, dass gleichzeitig zumindest zwei elektrische Felder zwischen einem als Sendeelektrode wirkenden ersten Sensorelement und zwei als Empfangselektroden wirkenden zweiten Sensorelementen ausgebildet werden, oder dass die zumindest zwei gleichzeitig ausgebildeten elektrischen Felder zwischen zwei als Sendeelektrode wirkenden ersten Sensorelementen und einem als Empfangselektrode wirkenden zweiten Sensorelement ausgebildet werden. Zusammengefasst sind somit bei dem erfindungsgemäßen Verfahren gleichzeitig zumindest immer wenigstens drei Sensorelemente aktiv bzw. an der Erzeugung elektrischer Felder beteiligt. Eine derartige Ausgestaltung des Verfahrens ermöglicht es daher, durch die Nutzung bzw. Auswertung einer Vielzahl von elektrischen Feldern die Reichweite zu erhöhen bzw. durch Überprüfung und Vergleich der einzelnen elektrischen Felder ggf. Fehlfunktionen des Sensorsystems entdecken zu können. Unter Sendeelektrode wird im Rahmen der Erfindung das Anlegen eines elektrischen Wechselfeldes an eine Elektrode bzw. ein Elektrodenelement verstanden. Unter Empfangselektrode wird das Messen von elektrischen Wechselfeldern an der Elektrode bzw. dem Elektrodenelement verstanden.

Vorteilhafte Weiterbildungen des erfindungsgemäßen Verfahrens zum Betreiben eines Sensorsystems sind in den Unteransprüchen aufgeführt.

In einer ersten konkreten Weiterbildung der soweit beschriebenen erfinderischen Grundidee ist es vorgesehen, dass alle nicht als Sendeelektrode wirkenden Sensorelemente gleichzeitig als Empfangselektrode geschaltet werden. Eine derartige Ausgestaltung des Verfahrens sichert eine maximale Reichweite bzw. ein möglichst frühes Erkennen einer möglichen Kollisionsgefahr und beschleunigt den Überwachungsablauf durch die gleichzeitige Durchführung mehrerer Messvorgänge. Darüber hinaus wird es in Kenntnis der Anordnung bzw. Position der einzelnen, als Empfangselektrode wirkenden Sensorelemente ermöglicht, durch eine Erfassung der Veränderungen der einzelnen elektrischen Felder beispielsweise besonders einfach eine mögliche Annäherung hinsichtlich einer potentiellen Gefahr analysieren zu können.

Zur Erzielung einer Redundanz, d.h. zur Sicherstellung bzw. Verifizierung der Analyse einzelner elektrischer Felder ist es darüber hinaus in einer weiteren Ausgestaltung des erfindungsgemäßen Verfahrens vorgesehen, dass mindestens zwei, vorzugsweise unmittelbar nebeneinander angeordnete Sensorelemente zeitlich aufeinanderfolgend als Sendeelektrode geschaltet werden, und dass das jeweils zuvor als Sendeelektrode wirkende Sensorelement als Empfangselektrode geschaltet wird.

In einer weiteren Ausgestaltung der Erfindung, die es ermöglicht, einen Abstand einer Person oder eines Objekts zu den Sensorelementen besser zu bestimmen, wird vorgeschlagen, dass Messsignale von räumlich nah zueinander angeordneten elektrischen Feldern mit Messsignalen von räumlich weit zueinander angeordneten elektrischen Feldern mittels eines Algorithmus verglichen werden.

Eine weitere vorteilhafte Ausgestaltung des erfindungsgemäßen Verfahrens, die insbesondere höhere Reichweiten des Sensorsystems in Bereichen mit baulichen Unterbrechungen (z.B. Spalten) ermöglicht, ist es vorgesehen, dass mehrere als Empfangselektrode wirkende Sensorelemente und/oder mehrere als Sendeelektrode wirkende Sensorelemente elektrisch zusammengeschaltet werden.

Grundsätzlich lässt sich ein zuvor analysiertes elektrisches Feld, unabhängig von der Distanz zwischen zwei Sensorelementen, d.h. auch bei zwischen den zwei Sensorelementen angeordneten weiteren Sensorelementen verifizieren bzw. redundant bestimmen, wenn in einem ersten Schritt ein zwischen zwei Sensorelementen ausgebildetes elektrisches Feld durch Betreiben eines ersten Sensorelements als Sendeelektrode und eines zweiten Sensorelements als Empfangselektrode erzeugt wird, und dass in einem zweiten Schritt das elektrische Feld durch Betreiben des zweiten Sensorelements als Sendeelektrode des ersten Sensorelements als Empfangselektrode erzeugt wird.

Erfindungsgemäß sieht das Verfahren vor, dass einige elektrische Felder gleichzeitig und andere elektrische Felder zeitlich nacheinander ausgebildet werden. Dadurch lassen sich erfindungsgemäß Bereiche an einer Maschine oder einem Roboter in unterschiedlich relevante Bereich unterteilen, derart, dass beispielsweise Bereiche, die sich mit relativ hoher Geschwindigkeit bewegen (beispielsweise ein Greifarm) hinsichtlich der Bewertung der Relevanz für eine mögliche Kollision anders bewertet werden als Bereiche eines Roboters (beispielsweise ein sich nicht bewegender Säulenbereich), von dem ausgegangen wird, dass eine geringere Kollisionsgefahr besteht. Dabei wird der besonders relevante Bereich dann erfindungsgemäß durch zeitlich gleichzeitig ausgebildete elektrische Felder überwacht.

Während beim Stand der Technik, wie im obigen Abschnitt erläutert, ein Sensorelement stets zwei elektrische Potentiale bzw. Elektroden aufweist, ist es im Rahmen der Erfindung durch gleichzeitige Nutzung mehrerer Sensorelemente zum Ausbilden von elektrischen Feldern möglich, ein Sensorelement zum Durchführen des erfindungsgemäßen Verfahrens derart auszubilden, dass das Sensorelement eine einzige Elektrode zur Ausbildung eines Teils eines elektrischen Felds aufweist, wobei die einzige Elektrode mit unterschiedlichem elektrischen Potential verbindbar ist, derart, dass die einzige Elektrode wahlweise als Empfangselektrode oder als Sendeelektrode wirkt. Ein derartiger Aufbau eines Sensorelements ist daher besonders einfach bzw. kostengünstig realisierbar, so dass insbesondere bei einer Vielzahl von Sensorelementen, wie dies bei großen zu überwachenden Maschinen bzw. Maschinenbauteilen erforderlich ist, bei denen die einzelnen Sensorelemente in Form einer Sensorhaut zusammengeschaltet werden, zusätzliche Kosteneinspareffekte erzielbar sind.

Zur effektiven und einfachen Ansteuerung der einzelnen Sensorelemente umfasst die Erfindung auch ein Sensorsystem, bei dem mehrere Sensorelemente dazu ausgebildet sind, entsprechend des oben beschriebenen erfindungsgemäßen Verfahrens betrieben zu werden, wobei die einzelnen Sensorelemente über ein Bussystem von einer gemeinsamen Zentraleinheit ansteuerbar sind.

Insbesondere ist das soweit beschriebene Sensorsystem in bevorzugter Art und Weise Teil einer Maschinensteuerung zur Erkennung der Annäherung von Objekten oder Körpern. Die Maschinensteuerung kann dabei so ausgebildet sein, dass beim Erkennen einer potentiellen Kollisionsgefahr die Maschinensteuerung die Maschine entweder in einen Ruhemodus oder in einen abgesicherten Modus überführt, bei dem eine Kollisionsgefahr zumindest reduziert ist.

Weitere Vorteile, Merkmale und Einzelheiten der Erfindung ergeben sich aus der nachfolgenden Beschreibung bevorzugter Ausführungsbeispiele sowie anhand der Zeichnung.

Diese zeigt in:
- Fig. 1 bis Fig. 4: ein aus mehreren Sensorelementen bestehendes Sensorsystem, bei dem zeitlich aufeinanderfolgend unterschiedliche elektrische Felder erzeugt werden, in einer vereinfachten Darstellung,
- Fig. 5: einen Querschnitt durch ein Sensorelement, wie es bei dem Sensorsystem gemäß der Fig. 1 bis 4 verwendet wird,
- Fig. 6 und Fig. 7: vereinfachte Darstellungen zur Darstellung der Ausbildung elektrischer Felder während zweier zeitlich aufeinanderfolgender Zyklen,
- Fig. 8: eine Darstellung eines Sensorsystems, bei dem zwischen Sensorelementen ausgebildete Totzonen erkannt werden und
- Fig. 9: ein vereinfachtes Schaltbild eines erfindungsgemäßen Sensorsystems als Bestandteil einer Maschinensteuerung.

Gleiche Elemente bzw. Elemente mit gleicher Funktion sind in den Figuren mit den gleichen Bezugsziffern versehen.

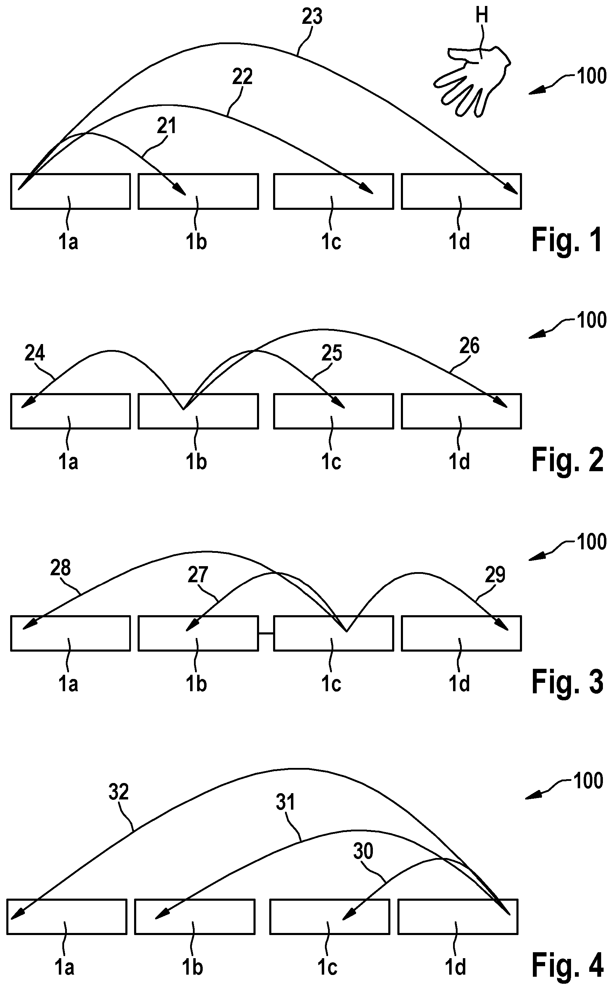

In den Fig. 1 bis 4 sind beispielhaft vier nebeneinander angeordnete kapazitive Sensorelemente 1a bis 1d als Bestandteil eines Sensorsystems 100 vereinfacht dargestellt. Insbesondere kann es vorgesehen sein, dass die Sensorelemente 1a bis 1d an einem Maschinenbauteil oder einem Roboter im Bereich eines beweglichen Bauteils, wie einem Greifarm oder ähnlichem, angeordnet sind. Die Anordnung der einzelnen Sensorelemente 1a bis 1d kann dabei beispielhaft über Klebeverbindungen an der Außenfläche des Bauteils erfolgen. Darüber hinaus wird erwähnt, dass lediglich beispielhaft und der besseren Übersichtlichkeit wegen vier Sensorelemente 1a bis 1d dargestellt sind. In der Praxis weist ein derartiges Sensorsystem 100 jedoch eine Vielzahl derartiger Sensorelemente 1a bis 1d auf, beispielsweise mehrere hundert Sensorelemente 1a bis 1d. Auch müssen die einzelnen Sensorelemente 1a bis 1d nicht zwangsläufig alle identisch ausgebildet sein und/oder dieselbe Größe aufweisen.

Desweiteren können mehrere der Sensorelemente 1a bis 1d baulich zusammengefasst sein, und beispielsweise auf einem gemeinsamen Schaltungsträger angeordnet werden. Bei den Sensorelementen 1a bis 1d handelt es sich somit um funktionell getrennte Einheiten, die jedoch baulich gesehen zwangsläufig nicht voneinander getrennt sein müssen.

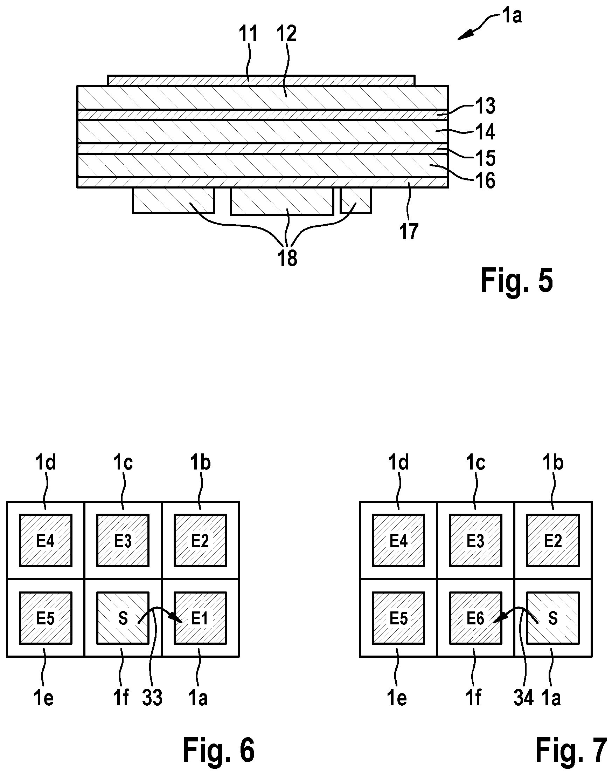

Hinsichtlich des möglichen Aufbaus eines derartigen Sensorelements 1a (bis 1d) wird nunmehr auf die Fig. 5 eingegangen. Dort ist erkennbar, dass das Sensorelement 1a auf der der äußeren Umgebung zugewandten Seite ein (aktives) Elektrodenelement 11 aufweist. Das dünne bzw. flächig ausgebildete Elektrodenelement 11 ist entweder als Sendeelektrode, oder aber als Empfangselektrode elektrisch schaltbar. Hierzu ist das Elektrodenelement 11 mit unterschiedlichem Spannungspotential verbindbar. Auf der der äußeren Umgebung abgewandten Seite schließt sich an das Elektrodenelement 11 ein erstes Träger- bzw. Zwischenelement 12 an. Auf der dem Elektrodenelement 11 abgewandten Seite des Zwischenelements 12 ist eine Schirmelektrode 13, die zumindest zum Zeitpunkt der Messung mit elektrischer Masse verbunden ist, angeordnet. An die Schirmelektrode 13 schließt sich eine zweite Zwischenschicht 14 an. An die zweite Zwischenschicht 14 schließt sich eine erste Signalschicht 15 an, an die sich wiederum eine dritte Zwischenschicht 16 anschließt. Auf der der ersten Signalschicht 15 abgewandten Seite der dritten Zwischenschicht 16 schließt sich eine zweite Signalschicht 17 an, auf der wiederum elektronische Bauelemente 18 angeordnet sind.

Mit Bezug auf die Fig. 1 bis 4 wird eine mögliche Betriebsweise des Sensorsystems 100 wie folgt erläutert: Zunächst ist entsprechend der Fig. 1 das Sensorelement 1a als Sendeelektrode geschaltet, während die benachbarten Sensorelemente 1b bis 1d jeweils als Empfangselektrode geschaltet sind bzw. wirken. Dadurch werden gleichzeitig drei elektrische (Wechsel-)Felder 21 bis 23 ausgebildet, die in der Fig. 1 beispielhaft durch jeweils eine einzige Feldlinie dargestellt sind. Das erste elektrische Feld 21 wird zwischen dem Sensorelement 1a und dem Sensorelement 1b ausgebildet. Das zweite elektrische Feld 22 wird zwischen dem Sensorelement 1a und dem Sensorelement 1c ausgebildet. Das dritte elektrische Feld 23 wird zwischen dem Sensorelement 1a und dem Sensorelement 1d ausgebildet. Alle drei elektrischen Felder 21 bis 23 können mittels einer in den Fig. 1 bis 4 nicht dargestellten Auswerteeinrichtung überwacht werden, um damit beispielsweise die Annäherung einer Hand H an die elektrischen Felder 21 bis 23 zu erkennen.

Nach der Ausbildung der elektrischen Felder 21 bis 23 werden anschließend entsprechend der Fig. 2 drei weitere elektrische Felder 24 bis 26 ausgebildet. Die elektrischen Felder 24 bis 26 bilden sich dadurch aus, dass nunmehr das Sensorelement 1b als Sendeelektrode betrieben wird, während die Sensorelemente 1a, 1c und 1d als Empfangselektrode wirken.

Anschließend werden entsprechend der Fig. 3 wiederum drei elektrische Felder 27 bis 29 ausgebildet. Dabei wird das Sensorelement 1c als Sendeelektrode betrieben, während die Sensorelemente 1a, 1b und 1d als Empfangselektrode wirken.

Zuletzt werden entsprechend der Fig. 4 drei elektrische Felder 30 bis 32 erzeugt, wobei die Sensorelemente 1a, 1b und 1c als Empfangselektrode wirken, während das Sensorelement 1d als Sendeelektrode wirkt.

Anschließend können die elektrischen Felder 21 bis 32 entsprechend der Figurenfolge der Fig. 1 bis 4 erneut ausgebildet werden, oder aber in einer umgekehrten Reihenfolge, oder alternativ in einer beliebigen Reihenfolge.

In den Fig. 6 und 7 ist eine weitere Betriebsart des Sensorsystems 100 unter Verwendung von sechs Sensorelementen 1a bis 1f dargestellt. Zur Verdeutlichung, welches der Sensorelemente 1a bis 1f als Sendeelektrode bzw. als Empfangselektrode wirkt, werden die als Empfangselektroden wirkenden Sensorelemente 1a bis 1f mit E1 bis E6 bezeichnet, während ein als Sendeelektrode wirkendes Sensorelement mit S bezeichnet ist.

Anhand der Fig. 6 ist erkennbar, dass zu einem ersten Zeitpunkt das Sensorelement 1f als Sendeelektrode S wirkt, während das benachbarte Sensorelement 1a als Empfangselektrode E1 wirkt. Zwischen den beiden Sensorelementen 1a und 1f ist ein elektrisches Feld 33 ausgebildet. Anschließend wird entsprechend der Fig. 7 die Funktionsweise der beiden Sensorelemente 1a und 1f umgekehrt, derart, dass nunmehr das Sensorelement 1a als Sendeelektrode S wirkt, während das Sensorelement 1f als Empfangselektrode E6 wirkt. Dabei wird zwischen den beiden Sensorelementen 1a und 1f ein elektrisches Feld 34 ausgebildet.

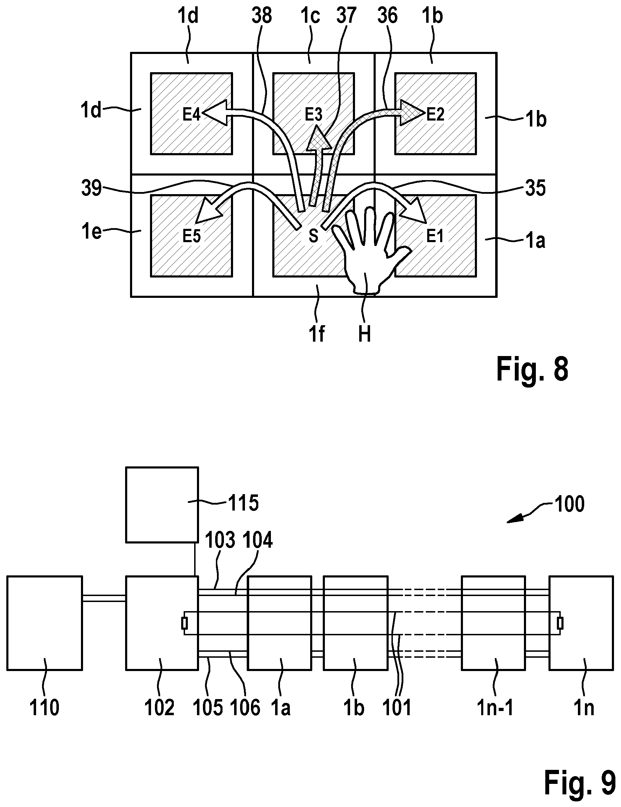

In der Fig. 8 ist dargestellt, wie bei Verwendung von sechs Sensorelementen 1a bis 1f ein sich zwischen den beiden Sensorelementen 1a und 1f näherndes Objekt in Form einer Hand H erkannt wird. Wesentlich dabei ist, dass bei der Annäherung der Hand H aus einer Richtung, bei der ein zwischen den Sensorelementen 1a und 1f ausgebildetes elektrisches Feld 35 nicht verändert wird, die Annäherung der Hand H an das Sensorsystem 100 durch eine Änderung der elektrischen Felder 36 und 37 zwischen den Sensorelementen 1f und 1b sowie 1f und 1c erkannt wird. Auch die beiden elektrischen Felder 38 und 39 zwischen dem Sensorelement 1f und dem Sensorelement 1d bzw. dem Sensorelement 1e ändern sich beispielhaft bei der Annäherung der Hand H an das Sensorsystem 100 nicht.

In der Fig. 9 ist der Aufbau bzw. die Anordnung des Sensorsystems 100 weiter erläutert. Insbesondere erkennt man, dass eine Vielzahl von Sensorelementen 1a bis 1n in Art einer Kette über eine gemeinsame Busleitung 101 mit einer als Steuereinrichtung wirkenden Zentraleinheit 102 verbunden bzw. gekoppelt sind. Über die Zentraleinheit 102 erfolgt auch die Spannungsversorgung der einzelnen Sensorelemente 1a bis 1n über Anschlussleitungen 103, 104. Weiterhin bestehen sowohl zwischen den einzelnen Sensorelementen 1a bis 1n als auch zwischen dem Sensorelement 1a und der Zentraleinheit 102 jeweils serielle Verbindungen 105, 106 zum Datenaustausch. Die Zentraleinheit 102 ist mit einer Maschinensteuerung 110 verbunden, die bei Annäherung eines Objekts oder einer Person die Maschine beispielsweise in einem abgesicherten Modus betreibt oder abstellt. Weiterhin ist die Zentraleinheit 102 über einen Rechner 115 konfigurierbar.

Ergänzend wird erwähnt, dass die Erkennung der Annäherung eines Objekts oder einer Person bei den Sensorelementen 1a bis 1f durch eine analoge, digitale oder gemischt analog/digitale Schaltung realisiert werden kann. Darüber hinaus wird erwähnt, dass im Gegensatz zur Darstellung der Fig. 5 die Sensorelemente 1a bis 1f auch dadurch ausgebildet bzw. realisiert werden können, dass entweder, wie in der Fig. 5 dargestellt, jeder Elektrode 11 ein separates Sensorelement 1a bis 1f bzw. ein eigenes Substrat zugeordnet ist, oder aber, dass mehrere Elektroden 11 der Sensorelemente 1a bis 1f auf einem gemeinsamen Substrat angeordnet sind.

Auch kann der Schichtaufbau eines Sensorelements 1a bis 1f von der in der Fig. 5 gezeigten Art und Weise des Aufbaus abweichen. So kann es beispielsweise möglich sein, neben dem aktiven Elektrodenelement 11 keine weiteren Elektrodenelemente vorzusehen. Auch kann beispielsweise zwischen dem Elektrodenelement 11 und der Schirmelektrode 13 eine Bias-Elektrode angeordnet bzw. geschaltet sein. Weiterhin kann es vorgesehen sein, dass ein Elektrodenelement 11 nur als Sendeelektrode bzw. Empfangselektrode ausgebildet ist. Darüber hinaus kann es vorgesehen sein, das soweit beschriebene Sensorsystem 100 bzw. die Sensorelemente 1a bis 1f z. B. auch in (aus Kunststoff bestehenden) Gehäuseschalen eines Industrieroboters oder einer Maschine anzuordnen. Die elektronischen Bauteile können auf dem gleichen Substrat wie die Elektrodenelemente angeordnet sein, oder - zumindest einige der Bauteile - auf einem baulich getrennten Schaltungsträger.

Eine weitere Beschleunigung des Messvorgangs kann dadurch erzielt werden, dass eine oder mehrere als Sendeelektroden wirkenden Sensorelemente 1a bis 1n gleichzeitig mit unterschiedlichen Sendefrequenzen betrieben werden, und dass die unterschiedlichen Sendefrequenzen von den als Empfangselektroden wirkenden Sensorelementen 1a bis 1n gleichzeitig erfasst werden, beispielsweise durch Nutzung von Filtern.

Hinsichtlich des Auswerteverfahrens der elektrischen Felder 21 bis 38 wird erwähnt, dass ein Vergleich der Messwertänderung jedes elektrischen Feldes 21 bis 38 oder daraus berechneter Kennzahlen mit einem oberen oder unteren Grenzwert für jedes elektrische Feld 21 bis 38 stattfinden kann, wobei bei Unter- oder Überschreitung die Maschinensteuerung 110 in einen sicheren Zustand überführt wird. Auch kann auf eine dynamische Annäherung eines Objekts oder einer Person geschlossen werden, wenn die Änderung eines Messwertes eines elektrischen Feldes 21 bis 38 schneller erfolgt als ein vorgegebener Grenzwert. Durch Einbeziehen der Messwerte von benachbarten Sensorelementen 1a bis 1n und Verarbeitung mit geeigneten Algorithmen, um die Messwerte zu plausibilisieren bzw. um bei Sensorelementen 1a bis 1n, die nicht in festem räumlichen Bezug zueinander stehen, wird eine zuverlässige Erkennung von sicherheitskritischen Annäherungen ermöglicht.

Hinsichtlich möglicher Anwendungen wird neben dem Einsatz bei Industrieanlagen bzw. Industrierobotern erwähnt, dass ein derartiges Sensorsystem 100 beispielsweise auch in einem Karosserieteil eines Kraftfahrzeugs, wie einer Stoßstange, eingebaut sein kann, um damit z.B. eine Assistenz- und Sicherheitsfunktionen zu erfüllen.

## Patentansprüche

1. Verfahren zum Betreiben eines Sensorsystems (100), mit wenigstens drei Sensorelementen (1a bis 1n), die an der Oberfläche von Maschinen oder Bauteilen anbringbar sind, wobei die Sensorelemente (1a bis 1n) jeweils eine Elektrode (11) zur Ausbildung elektrischer Felder (21 bis 39) aufweisen, wobei die Elektroden (11) mit unterschiedlichem elektrischem Potential verbindbar sind, derart, dass die Elektroden (11) als Sendeelektrode (S) oder als Empfangselektrode (E1 bis E6) wirken, wobei sich die elektrischen Felder (21 bis 39) bei Annäherung und/oder einem Kontakt eines Objekts verändern, wobei die Sensorelemente (1a bis 1n) in einer bestimmten zeitlichen oder örtlichen Reihenfolge von einer Steuereinrichtung (102) nacheinander angesteuert werden, und wobei entweder gleichzeitig zumindest zwei elektrische Felder (21 bis 39) zwischen einem als Sendeelektrode (S) wirkenden ersten Sensorelement (1a bis 1n) und zwei als Empfangselektrode (E1 bis E6) wirkenden zweiten Sensorelementen (1a bis 1n) oder zwischen zwei als Sendeelektrode (S) wirkenden ersten Sensorelementen (1a bis 1n) und einem als Empfangselektrode (E1 bis E6) wirkenden zweiten Sensorelement (1a bis 1n) ausgebildet werden,
**dadurch gekennzeichnet,**
**dass** die Sensorelemente (1a bis 1n) an hinsichtlich einer Kollisionsgefahr unterschiedlich relevanten Bereichen der Maschine angeordnet werden, und dass entsprechend der Relevanz der Bereiche einige elektrische Felder (21 bis 39) gleichzeitig und andere elektrische Felder (21 bis 39) zeitlich nacheinander ausgebildet werden, wobei die relevanten Bereiche durch zeitlich gleichzeitig ausgebildete elektrische Felder (21 bis 39) überwacht werden.

2. Verfahren nach Anspruch 1,
**dadurch gekennzeichnet,**
**dass** alle nicht als Sendeelektrode (S) wirkenden Sensorelemente (1a bis 1n) gleichzeitig als Empfangselektrode (E1 bis E6) geschaltet werden.

3. Verfahren nach Anspruch 1 oder 2,
**dadurch gekennzeichnet,**
**dass** mindestens zwei, vorzugsweise unmittelbar nebeneinander angeordnete Sensorelemente (1a bis 1n) zeitlich aufeinanderfolgend als Sendeelektrode (S) geschaltet werden, und dass vorzugsweise das jeweils zuvor als Sendeelektrode (S) wirkende Sensorelement (1a bis 1n) als Empfangselektrode (E1 bis E6) geschaltet wird.

4. Verfahren nach einem der Ansprüche 1 bis 3,
**dadurch gekennzeichnet,**
**dass** Messsignale von räumlich nah zueinander angeordneten elektrischen Feldern (21 bis 39) mit Messsignalen von räumlich weit zueinander angeordneten elektrischen Feldern (21 bis 39) mittels eines Algorithmus verglichen werden.

5. Verfahren nach einem der Ansprüche 1 bis 4,
**dadurch gekennzeichnet,**
**dass** mehrere als Empfangselektrode (E1 bis E6) wirkende Sensorelemente (1a bis 1n) und/oder mehrere als Sendeelektrode (S) wirkende Sensorelemente (1a bis 1n) elektrisch zusammengeschaltet werden.

6. Verfahren nach einem der Ansprüche 1 bis 5,
**dadurch gekennzeichnet,**
**dass** in einem ersten Schritt ein zwischen zwei Sensorelementen (1a bis 1n) ausgebildetes elektrisches Feld (21 bis 39) durch Betreiben eines ersten Sensorelements (1a bis 1n) als Sendeelektrode (S) und eines zweiten Sensorelements (1a bis 1n) als Empfangselektrode (E1 bis E6) erzeugt wird, und dass in einem zweiten Schritt das elektrische Feld (21 bis 39) durch Betreiben des zweiten Sensorelements (1a bis 1n) als Sendeelektrode (S) und des ersten Sensorelements (1a bis 1n) als Empfangselektrode (E1 bis E6) erzeugt wird.

7. Verfahren nach einem der Ansprüche 1 bis 6,
**dadurch gekennzeichnet,**
**dass** beim Betrieb mehrerer Sensorelemente (1a bis 1n) als Sendeelektrode (S) diese mit unterschiedlichen Frequenzen betrieben werden.

8. Verfahren nach Anspruch 7,
**dadurch gekennzeichnet,**
**dass** wenigstens ein Sensorelement (1a bis 1n) als Empfangselektrode (E1 bis E6) geschaltet wird, und dass das wenigstens eine als Empfangselektrode (E1 bis E6) wirkende Sensorelement (1a bis 1n), insbesondere durch Verwendung von Filtern, dazu ausgebildet ist, die unterschiedlichen Frequenzen zu unterscheiden.

9. Sensorsystem (100), umfassend mehrere Sensorelemente (1a bis 1n), die dazu ausgebildet sind, ein Verfahren nach einem der Ansprüche 1 bis 8 durchzuführen, wobei die Sensorelemente (1a bis 1n) über ein Bussystem (101) von einer gemeinsamen Steuereinrichtung (102) ansteuerbar sind.

10. Sensorsystem nach Anspruch 9,
**dadurch gekennzeichnet,**
**dass** das Sensorsystem (100) Teil einer Maschinensteuerung zur Erkennung der Annäherung von Objekten ist.

## Claims

1. Method for operating a sensor system (100) having at least three sensor elements (1a to 1n) which can be attached to the surface of machines or components, wherein the sensor elements (1a to 1n) each have an electrode (11) for forming electric fields (21 to 39), wherein the electrodes (11) can be connected to a different electrical potential in such a way that the electrodes (11) act as a transmitting electrode (S) or as a receiving electrode (E1 to E6), wherein the electric fields (21 to 39) change during the approach of and/or in the event of contact with an object, wherein the sensor elements (1a to 1n) are controlled in succession in a certain temporal or local order by a control device (102), and wherein either at least two electric fields (21 to 39) are formed at the same time between a first sensor element (1a to 1n) acting as a transmitting electrode (S) and two second sensor elements (1a to 1n) acting as a receiving electrode (E1 to E6) or between two first sensor elements (1a to 1n) acting as a transmitting electrode (S) and a second sensor element (1a to 1n) acting as a receiving electrode (E1 to E6),
**characterized**
**in that** the sensor elements (1a to 1n) are arranged in areas of the machine that are of different relevance with respect to a risk of collision, and in that, according to the relevance of the areas, some electric fields (21 to 39) are formed at the same time and other electric fields (21 to 39) are formed in temporal succession, the relevant areas being monitored by means of electric fields (21 to 39) formed at the same time.

2. Method according to Claim 1,
**characterized**
**in that** all sensor elements (1a to 1n) that do not act as a transmitting electrode (S) are simultaneously connected as a receiving electrode (E1 to E6).

3. Method according to Claim 1 or 2,
**characterized**
**in that** at least two sensor elements (1a to 1n), preferably arranged directly next to each other, are connected in temporal succession as a transmitting electrode (S), and in that preferably the sensor element (1a to 1n) respectively previously acting as a transmitting electrode (S) is connected as a receiving electrode (E1 to E6).

4. Method according to one of Claims 1 to 3,
**characterized**
**in that** measurement signals from electric fields (21 to 39) arranged spatially close to each other are compared with measurement signals from electric fields (21 to 39) arranged spatially far apart from each other by means of an algorithm.

5. Method according to one of Claims 1 to 4,
**characterized**
**in that** a plurality of sensor elements (1a to 1n) acting as a receiving electrode (E1 to E6) and/or a plurality of sensor elements (1a to 1n) acting as a transmitting electrode (S) are electrically interconnected.

6. Method according to one of Claims 1 to 5,
**characterized**
**in that**, in a first step, an electric field (21 to 39) formed between two sensor elements (1a to 1n) is generated by operating a first sensor element (1a to 1n) as a transmitting electrode (S) and a second sensor element (1a to 1n) as a receiving electrode (E1 to E6), and in that, in a second step, the electric field (21 to 39) is generated by operating the second sensor element (1a to 1n) as a transmitting electrode (S) and the first sensor element (1a to 1n) as a receiving electrode (E1 to E6).

7. Method according to one of Claims 1 to 6,
**characterized**
**in that**, when operating a plurality of sensor elements (1a to 1n) as a transmitting electrode (S), they are operated at different frequencies.

8. Method according to Claim 7,
**characterized**
**in that** at least one sensor element (1a to 1n) is connected as a receiving electrode (E1 to E6), and in that the at least one sensor element (1a to 1n) acting as a receiving electrode (E1 to E6) is designed to distinguish the different frequencies, in particular by using filters.

9. Sensor system (100) comprising a plurality of sensor elements (1a to 1n) which are designed to carry out a method according to one of Claims 1 to 8, wherein the sensor elements (1a to 1n) can be controlled by a common control device (102) via a bus system (101).

10. Sensor system according to Claim 9,
**characterized**
**in that** the sensor system (100) is part of a machine controller for detecting the approach of objects.

## Revendications

1. Procédé de fonctionnement d'un système de détection (100) comprenant au moins trois éléments de détection (1a à 1n) qui peuvent être montés sur la surface de machines ou de composants, les éléments de détection (1a à 1n) comportant respectivement une électrode (11) destinée à produire des champs électriques (21 à 39), les électrodes (11) pouvant être connectées à des potentiels électriques différents, de sorte que les électrodes (11) agissent comme une électrode d'émission (S) ou comme une électrode de réception (E1 à E6), les champs électriques (21 à 39) variant à l'approche et/ou au contact d'un objet, les éléments de détection (1a à 1n) étant commandés successivement dans un ordre temporel ou spatial particulier par un dispositif de commande (102), et au moins deux champs électriques (21 à 39) étant produits simultanément soit entre un premier élément de détection (1a à 1n) agissant comme une électrode d'émission (S) et deux deuxièmes éléments de détection (1a à 1n) agissant comme une électrode de réception (E1 à E6), soit entre deux premiers éléments de détection (1a à 1n) agissant comme une électrode d'émission (S) et un deuxième élément de détection (1a à 1n) agissant comme une électrode de réception (E1 à E6),
**caractérisé en ce que**
les éléments de détection (1a à 1n) sont disposés sur des zones de la machine qui sont différemment pertinentes en ce qui concerne le risque de collision, et **en ce que** certains champs électriques (21 à 39) sont produits simultanément et d'autres champs électriques (21 à 39) sont produits successivement dans le temps en fonction de la pertinence des zones, les zones pertinentes étant surveillées par des champs électriques (21 à 39) produits simultanément dans le temps.

2. Procédé selon la revendication 1,
**caractérisé en ce que**
tous les éléments de détection (1a à 1n) n'agissant pas comme une électrode d'émission (S) sont connectés simultanément comme une électrode de réception (E1 à E6).

3. Procédé selon la revendication 1 ou 2,
**caractérisé en ce que**
au moins deux éléments de détection (1a à 1n), de préférence disposés à proximité immédiate l'un de l'autre, sont connectés successivement dans le temps comme une électrode d'émission (S), et **en ce que**, de préférence, l'élément de détection (1a à 1n) ayant agi précédemment comme une électrode d'émission (S) est connecté comme une électrode de réception (E1 à E6).

4. Procédé selon l'une quelconque des revendications 1 à 3,
**caractérisé en ce que**
des signaux de mesure provenant de champs électriques (21 à 39) situés spatia-lement à proximité les uns des autres sont comparés au moyen d'un algorithme à des signaux de mesure provenant de champs électriques (21 à 39) situés à grande distance spatiale les uns des autres.

5. Procédé selon l'une quelconque des revendications 1 à 4,
**caractérisé en ce que**
plusieurs éléments de détection (1a à 1n) agissant comme une électrode de réception (E1 à E6) et/ou plusieurs éléments de détection (1a à 1n) agissant comme une électrode d'émission (S) sont connectés électriquement les uns aux autres.

6. Procédé selon l'une quelconque des revendications 1 à 5,
**caractérisé en ce que**
lors d'une première étape, un champ électrique (21 à 39) produit entre deux éléments de détection (1a à 1n) est généré en faisant fonctionner un premier élément de détection (1a à 1n) comme une électrode d'émission (S) et un deuxième élément de détection (1a à 1n) comme une électrode de réception (E1 à E6), et **en ce que**, lors d'une deuxième étape, le champ électrique (21 à 39) est généré en faisant fonctionner le deuxième élément de détection (1a à 1n) comme une électrode d'émission (S) et le premier élément de détection (1a à 1n) comme une électrode de réception (E1 à E6).

7. Procédé selon l'une quelconque des revendications 1 à 6,
**caractérisé en ce que**
lors du fonctionnement de plusieurs éléments de détection (1a à 1n) comme une électrode d'émission (S), ceux-ci fonctionnent à des fréquences différentes.

8. Procédé selon la revendication 7,
**caractérisé en ce que**
au moins un élément de détection (1a à 1n) est connecté comme une électrode de réception (E1 à E6), et **en ce que** l'au moins un élément de détection (1a à 1n) agissant comme une électrode de réception (E1 à E6) est conçu pour distinguer les différentes fréquences, en particulier par l'utilisation de filtres.

9. Système de détection (100), comprenant plusieurs éléments de détection (1a à 1n) qui sont conçus pour mettre en œuvre un procédé selon l'une quelconque des revendications 1 à 8, les éléments de détection (1a à 1n) pouvant être commandés par un dispositif de commande commun (102) par l'intermédiaire d'un système de bus (101).

10. Système de détection selon la revendication 9,
**caractérisé en ce que**
le système de détection (100) fait partie d'une unité de commande de machine destinée à détecter l'approche d'objets.
